# EUROPEAN PATENT SPECIFICATION

(11) **EP 0 504 420 B1**
(45) Date of publication and mention of the grant of the patent: **23.07.1997**
(21) Application number: 91917070.4
(22) Date of filing: 05.10.1991
(51) Int. Cl.: G03F 7/42, H01L 21/02

(54) **STEAM SUPPLIER**
WASSERDAMPFVERSORGUNGSEINRICHTUNG
ALIMENTATEUR DE VAPEUR D'EAU

(30) Priority: 05.10.1990 JP 267985/90; 05.10.1990 JP 267986/90
(43) Date of publication of application: 23.09.1992
(73) Proprietor: FUJITSU LIMITED, Kawasaki-shi, Kanagawa 211 (JP); SHINKO SEIKI CO., LTD., Kobe-shi, Hyogo 651-22 (JP)
(72) Inventor: SHINAGAWA, Keisuke, Fujitsu Limited, Kawasaki-shi Kanagawa 211 (JP); FUJIMURA, Shuzo, Fujitsu Limited, Kawasaki-shi Kanagawa 211 (JP); MATOBA, Yuuji, Shinko Seiki Co., Ltd., Kobe-shi Hyogo 651-22 (JP); NAKANO, Yoshimasa, Shinko Seiki Co., Ltd., Nishi-ku Kobe-shi Hyogo 651-22 (JP); TAKEUCHI, Tatsuya, Shinko Seiki Co., Ltd., Nishi-ku Kobe-shi Hyogo 651-22 (JP); MIYANAGA, Takeshi, Shinko Seiki Co., Ltd., Nishi-ku Kobe-shi Hyogo 651-22 (JP)
(74) Representative: Rackham, Stephen Neil
(86) International application number: PCT/JP91/01361
(87) International publication number: WO 92/06488

(56) References cited:
- EP-A- 0 174 673
- EP-A- 0 343 355
- FR-A- 1 530 914
- JP-A-64 030 225
- US-A- 3 348 984
- US-A- 4 640 221
- US-A- 4 761 269

## Description

This invention relates to a steam supplying apparatus and more particularly to an apparatus for supplying steam to a vacuum chamber to perform an ashing process of a photoresist (exfoliation process of organic film) in a production process of semiconductor devices or the like.

Recently, in the field of semiconductor devices, liquid crystals, high polymer materials, ceramics or the like, a gas phase process is sometimes conducted with plasma or the like to treat the surface of a work in a vacuum or pressure reduction environment, because it is easy to control the process. Such a system is disclosed in US-A-4640221.

However, the pressure of gas suitable for this process is not always high enough. The pressure of steam is low, i.e. about 2700 Pa (20 Torr) at room temperature and depends deeply on the temperature of the steam. Therefore, steam is one gas which is difficult to supply a large amount of in a good controlled condition.

Particularly, in a production of semiconductor devices, steam is used as one of the reaction gases in an ashing process for resist or other resin films. Therefore, an apparatus is required for stably supplying steam so as to improve a process accuracy.

Steam supplying apparatus is used to supply the steam from a closed water tank containing water via a mass-flow controller to a vacuum chamber.

Recently, it is required to stably supply the steam without raising so much the temperature of a pipe system including pipes other than the water tank, valves and the mass-flow controller compared with the water temperature in the water tank, and without the steam causing a blockage in the mass-flow controller.

The present invention can be applied to a steam supplying apparatus and a control method thereof which satisfy the above-mentioned requirements.

In many cases, a steam generation chamber containing water to be supplied to a vacuum chamber is made of quartz, which has some drawbacks, such as an uneven temperature and difficulty in precise control of flow (amount of evaporation), since quartz may easily be damaged and does not have a good thermal conductivity. Also, recently a metal chamber having an inside surface made of soda glass coated with enamel is known. However, in this case, foreign substances (Na, Fe, Ca or the like) in the glass may enter into the water and may become contaminents.

In a steam supplying method, the steam is supplied by a pressure difference between a saturated vapor pressure of the steam (about 3200 Pa (24 Torr) at 25°C) and the inside pressure of the chamber.

Therefore, to keep the flow of steam supply constant, it is necessary to keep the temperature of the steam generation chamber constant. However, in the prior art, the temperature control is conducted by a mantle heater, which has its own limitation and has not been sufficient.

In the prior art, the steam may sometimes deteriorate the pump oil of a rotary pump or the like and remain in the vacuum chamber to reduce the vacuum, so that the steam is one of the most unfavorable gases which is introduced into the vacuum chamber. Thus, a method for positively introducing steam to a vacuum chamber has not been developed.

Where steam is to be positively introduced, carrier gas is introduced through water to perform a bubbling process and the carrier gas is then introduced into the vacuum chamber.

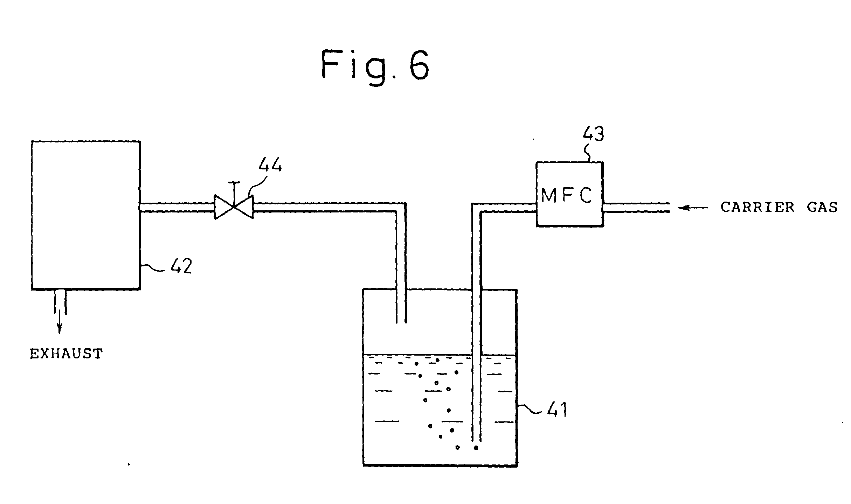

Fig. 6 is a schematic diagram for explaining a steam supply system in the prior art.

In the drawing, 41 denotes a bubbler with water; 42, a vacuum chamber to perform a gas process; 43, a mass-flow controller (MFC); and 44, a valve.

Carrier gas is introduced via the mass-flow controller (MFC) into the water in the bubbler 41 to perform a gas process. The bubbled steam is introduced into the vacuum chamber 42 with the carrier gas.

In this method, the amount of steam actually introduced depends on the pressure of steam in the mixed gas of the carrier gas and the steam. In general, the vapour pressure of the carrier gas is higher than that of the steam and, therefore, the amount of steam introduced is not as high as that of the carrier gas.

Therefore, in order to introduce more steam, it will be necessary to use a large amount of carrier gas and a large air exhaust system will be required to maintain the vacuum chamber to be a vacuum condition.

Therefore, in the prior art apparatus, it is difficult to stably control the flow of steam. Further, the steam may contain some contaminents.

A temperature control of steam in the prior art will now be described.

A conventional method for introducing the steam to a vacuum system comprises a water tank, pipes and a mass-flow controller which are arranged in a constant temperature system and their temperature is uniformly controlled. However, this method has problems, such as, the constant temperature system itself is relatively large, requires a lot of cost, and is difficult to control their temperature.

Another conventional method to solve such problems, comprises controlling the amount of steam by controlling the water temperature in the water tank, and to raise the temperature in the pipes other than the water tank and the mass-flow controller so as not to be blocked.

Now, the prior art will be described with reference to the drawing.

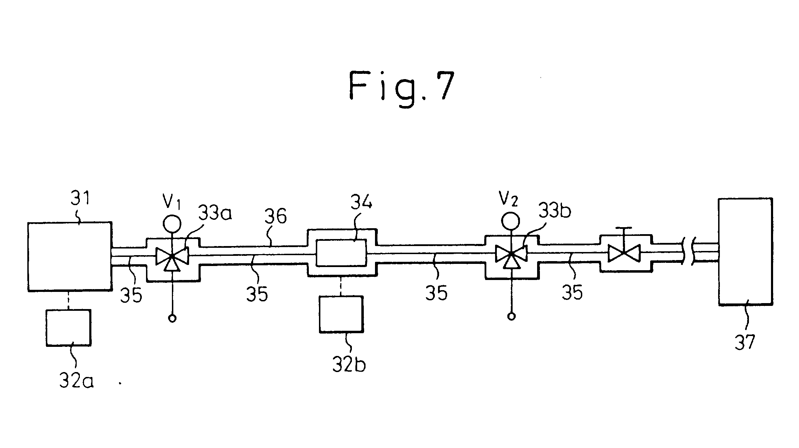

Fig. 7 is a schematic diagram of a steam supplying method and a steam supplying apparatus having a mass-flow controller. The illustrated steam supplying apparatus can be applied to a pressure reduction CVD (Chemical vapor deposition) or the like. In Fig. 7, 31 denotes a water tank; 32a and 32b, temperature control means; 33a and 33b, valves; 34, a mass-flow controller; 36, a heater; and 37, a vacuum chamber.

As shown in Fig. 7, the flow from the water tank 31 is determined by the steam flow (an amount of evaporation of water) and temperature of the water tank 31 is controlled with a double bath system by a temperature control means 32a. As the pressure curve of the water evaporation is relatively sharp compared with TEOS (Tetra ethyl orthosilicate; Si(OC₂H₅)₄), it is preferred to precisely control the temperature of the water tank 31 by the temperature control means 32a.

The temperature in the pipes other than the water tank 31, namely the pipes 35, the valves 33a and 33b and the mass-flow controller 34 is raised by a tube heater 36 and the temperature control means 32b so that the steam is not blocked. The heater 36 is provided to enclose entirely the pipes 35, the valves 33a and 33b and the mass-flow controller 34 and the temperature control means 32b is provided, such as at the mass-flow controller 34, to cover these pipes 35 so as to control the temperature thereof.

In the above-mentioned steam supplying apparatus in the prior art, as shown in Fig. 7, the pipes other than the water tank 31, namely the pipes 35, the valves 33a and 33b and the mass-flow controller 34 are entirely covered by the heater 36 and the temperature thereof is controlled by a single temperature control means 32b. In this steam supplying apparatus, the water temperature in the water tank 31 necessary to supply the steam at a flow rate of 600 cm³/min. is typically 50°C. The temperature of the pipe system including the pipes 35, the valves 33a and 33b and the mass-flow controller 34 must be kept over 60 °C by the heater 36 and the temperature control means 32b to prevent the steam from being blocked.

The water temperature in the water tank 31 must be 55 °C necessary to supply the steam at a flow rate of 900 cm³/min and, in this case, the temperature of the pipe system other than the water tank 31 must be over 80 °C.

If it is necessary to supply the steam at a flow rate of 1100 cm³/min. the water temperature in the water tank 31 must be 60°C. However, in this case, even if the temperature of the pipe system other than the water tank 31 was raised to 90 °C, the steam would be blocked at the mass-flow controller 34. Also, in this conventional steam supplying apparatus, depending on the structure and thermal capacity of the mass-flow controller 34, the temperature of the inner wall of the mass-flow controller 34, at the steam passing portion thereof, is a little lower than that of the front and rear parts thereof. As the results, there is a great possibility to create dewdrops.

Thus, if a large amount of steam is to be supplied, such as a flow rate of 1100 cm³/min., the amount of evaporation from the water tank 31 is increased as an exponential function and, therefore, the amount of steam from the water tank 31 can be increased by increasing the temperature or the area of the water surface. However, to prevent the pipes other than the water tank 31 from being blocked with steam, there would be a problem that the pipes must be kept at a relatively high temperature. In particular, to heat over 100 °C, it would be difficult to use resin in view of its heatproof capacity. If a metal is used in place of resin as a material of the pipes, the metal is generally subjected to an erosion and, when it is used in manufacturing semiconductor devices, it may cause metal contamination. Therefore, using a metal is not appropriate.

According to the present invention, a steam supplying apparatus for supplying steam to a vacuum chamber is characterised in that the apparatus comprises a closed chamber for containing water to be evaporated, the chamber having a ratio of maximum horizontal cross-sectional area to minimum horizontal cross-sectional area of less than 8:1, the inner surface coated with resin, a steam outlet and a means for heating the closed chamber.

The apparatus according to the present invention allows easy control of the temperature of the steam, by virtue of the ratio of maximum to minimum cross-sectional area, and the provision of a resin reduces the contamination in the steam. Preferably, a temperature controlled liquid bath is used to heat the closed chamber.

A mass-flow controller is advantageously provided between the closed chamber and vacuum chamber, and is used to control the flow rate of steam to between 50 and 100% of the maximum flow rate determined by the vapour pressure of the system. This helps ensure the steam causes no blockages in the system. The temperature of the closed chamber is preferably controlled so the maximum flow rate is below the maximum flow rate capacity of the mass-flow controller. This gives the optimum range of control of the steam flow rate.

It is advantageous to provide heaters on the pipes interconnecting the closed chamber, the mass-flow controller and vacuum chamber to control the temperature (Tp) of the pipes. Preferably, a heater is also included to control the temperature (Tm) of the mass-flow controller. In this way, the temperatures may independently be controlled so that the temperature (Tt) in the closed chamber is not greater than Tp, which is not greater than Tm. With this arrangement, it is not necessary to raise the overall system temperature as high as with the prior art systems, and accordingly the disadvantages of such a temperature increase are avoided.

The resin coating on the inner surface of the closed chamber is preferably Teflon.

In practice, the water surface is away from the outlet by over 1 cm, so that even if a deaeration occurs in the steam generation chamber, water would not enter the outlet.

A method for controlling the above-mentioned steam flow will now be described.

If steam is supplied from a closed steam generation chamber to a vacuum chamber via a mass-flow controller, the maximum flow is determined by the inductance of the steam supply system and the water temperature in the steam generation chamber (however, the water temperature must be kept high in the pipes to prevent the steam to be liquid).

If the maximum flow is 500 cm³/min. at the water temperature 50°C, and if the mass-flow controller has an allowable flow of more than 500 cm³/min., the flow control must be done in a range of about 0-500 cm³/min., and if the mass-flow controller has an allowable flow of less than 500 cm³/min., the flow control must be done in a range of about 0 to the maximum allowable flow of the mass-flow controller.

However, if the flow in the mass-flow controller was reduced. the steam would become liquid and the mass-flow controller would be blocked. The reason is that, when the steam passes through the orifice of the mass-flow controller, the steam is cooled with an adiabatic cooling due to a pressure difference between the up and downstream of the mass-flow controller . Therefore, the actual controllable flow range depends on the pressure of steam in the supply system.

As described hereinafter in the embodiment, if the range of flow of the steam controlled by the mass-flow controller is 50-100% of the maximum steam flow determined by a steam pressure in the steam supply system, it has been found that blockage will not occur.

The above mentioned vacuum chamber may be a chamber for a pressure reduction CVA, a pressure reduction oxidization, or a plasma generation (CVD or etching) or the like.

The operation of the above-mentioned steam supply method and apparatus.

Among the steam supplying apparatus, the mass-flow controller has a large thermal capacity and the most narrow part in which the steam passes through is an orifice in the mass-flow controller. Therefore, steam may easily be blocked in the mass-flow controller. The reason is that, when the steam passes through the orifice of the mass-flow controller, the steam may be cooled with an adiabatic cooling due to a pressure difference between the up and downstream of the orifice. Therefore, to prevent the blockage of steam, where the temperature must be most increased is only the orifice of the mass-flow controller. Therefore, according to the present invention, the water temperature Tt in the water tank, the temperature Tp in the pipes from the water tank to the mass-flow controller and from the mass-flow controller to the vacuum chamber, and the temperature Tm in the mass-flow controller are preferably controlled so as Tt ≦ Tp ≦ Tm.

Thus, the temperature reduction due to the adiabatic cooling at the orifice in the mass-flow controller will be hard to occur and prevented from becoming liquid.

The present invention will be described and contrasted with the prior art with respect to the accompanying drawings in which:
Figure 1 is a schematic diagram of the apparatus of an embodiment of this invention;
Figure 2 is a view showing a characteristic of downstream ashing using oxygen and steam;
Figure 3 is a schematic diagram of an apparatus used in an experiment of the flow control in a mass-flow controller;
Figure 4 is a view showing the relationship between the maximum flow and water temperature;
Figure 5 is a view showing another embodiment of a steam supplying apparatus and a method for controlling the same;
Figure 6 is a schematic diagram for explaining a prior art steam supply system; and,
Figure 7 is a schematic diagram of a second prior art steam supply method and apparatus having a mass-flow controller;

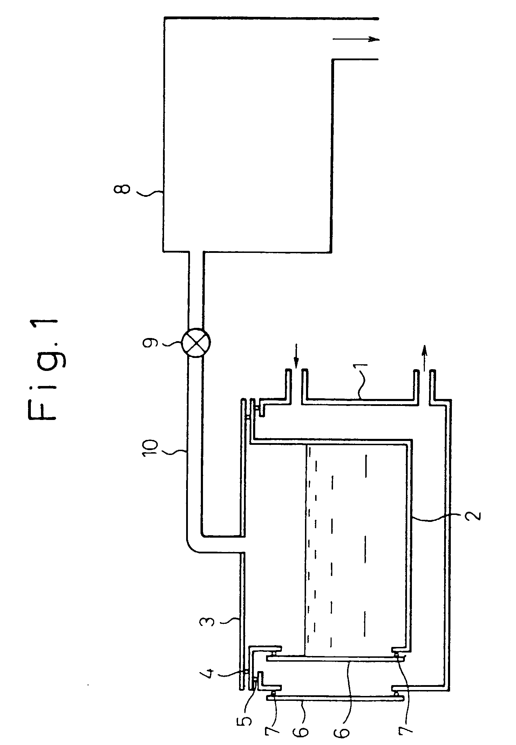

Figure 1 is a schematic diagram of the apparatus of an embodiment of this invention.

In the drawing, a steam generation chamber 2 and its upper cover 3 are made of aluminum alloy, an inside surface thereof is coated with a resin such as thick tritetrafluoroethylene (Teflon: trademark) to prevent the exposure of aluminum alloy and to avoid forming pin holes.

In addition, the steam generation chamber 2 is provided with a liquid level monitoring window 6 made of clear quartz glass and sealed with packing 7 made of rubber containing no foreign matters.

The space between the body 1 and the steam generation chamber 2 is a hot water tank, the water temperature is controlled by a chiller (liquid circulation device), and the hot water circulates through an inlet and an outlet.

Air is discharged from the steam generation chamber 2, which is filled with steam on use.

The thermal conductivity and the temperature control of the steam generation chamber 2 is high and good, so that a certain temperature is easily maintained.

In a test that the steam generation chamber 2 was filled with pure water and maintained at 50°, the results of analysis of foreign matters were as follows before and after 20 days.

| Kind of Foreign Matters | Na | Fe | Ca |
|---|---|---|---|
| Initial Amount (mg/ ℓ ) | 0.05 | 0.01 | 0.12 |
| Start Amount (mg/ℓ ) | 0.16 ≦ | 0.01 ≦ | 0.02 |

According to this table, it is found that change of foreign matters is small.

In a separate experiment 1, the steam generation chamber 2 was made of aluminum and was not coated with tritetrafluoroethylene. Under the same conditions, the amount of foreign matters were much increased over 2-places tnan the above.

In a separate experiment 2, the steam generation chamber 2 was made of enameled soda glass and, under the same conditions, the amount of Fe and Ca were increased by several mg/ℓ and the Na was increased by ten-several mg/ℓ.

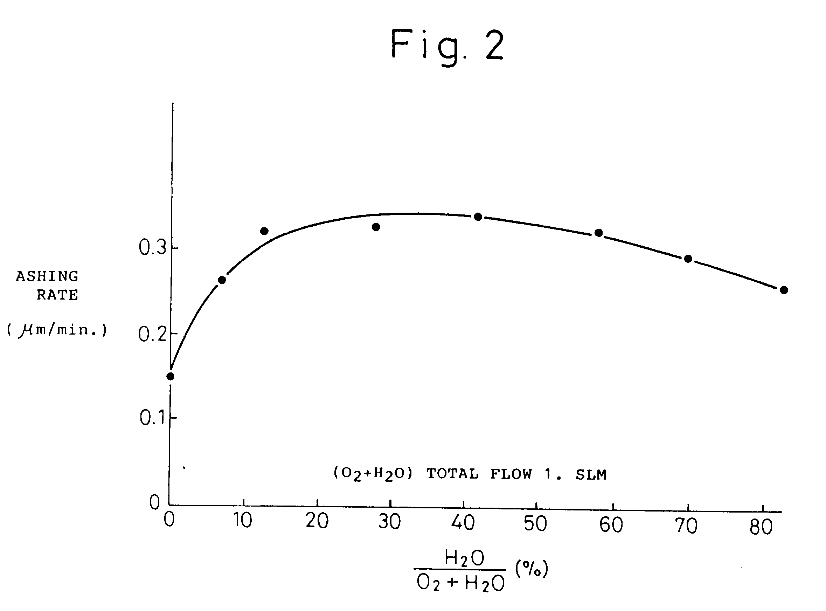

Fig. 2 is a view showing a characteristic of downstream ashing using oxygen and steam;

After ashing process, steam (H₂O) and oxygen (O₂) are supplied to the vacuum chamber via separate lines. That is, the steam is supplied to the vacuum chamber from the steam generation chamber 2 as shown in Fig. 1 and the oxygen is supplied from an oxygen bomb via valves or the like to the vacuum chamber 8, in which the gas is mixed.

It is found that, according to the ashing rate (length of exfoliation in a direction for a certain time) depending on H₂O / (O₂ + H₂O) % , it is necessary to supply the steam so that H₂O / (O₂ + H₂O) be a predetermined rate of flow determined from 10 to 80 % to attain a maximum ashing rate.

The flow of steam supplied from steam generation chamber 2 to the vacuum chamber 8 depends on the water surface area, assuming that the conductance of the pipe for connecting both chambers is constant. Therefore, it becomes necessary to determine the allowance in the change of water surface area. Thus, assuming that a maximum of the water surface area is M and a minimum thereof is S, if M/S < 8, the same ashing rate could be constantly obtained.

In an experiment, a conical chamber having an upper area S= 1 and a lower area M= 8 was used. In this case, during a change of water surface from S to M, the ashing rate was substantially constant as 0.28-0.30 µm/min. Contrary to this, using a chamber, M being more than 8, the ashing rate was not constant.

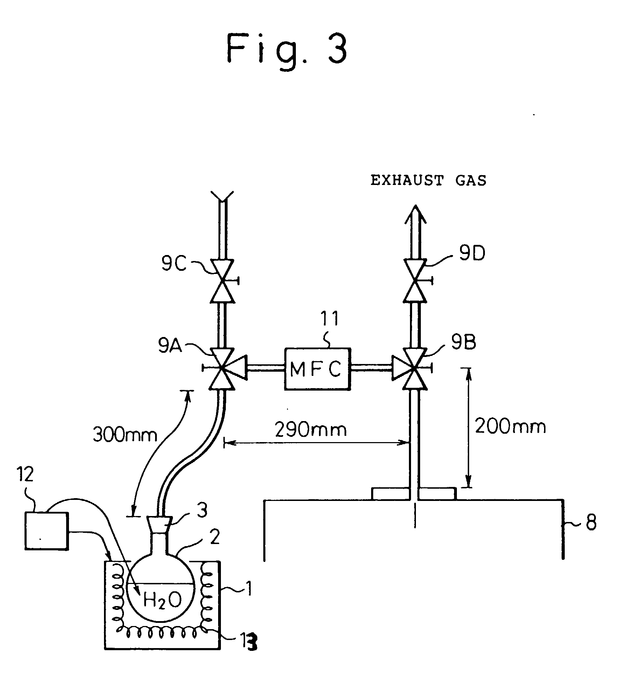

Fig. 3 is a schematic diagram of an apparatus used in an experiment of the flow control in a mass-flow controller.

In the drawing, the mass-flow controller (MFC) 11 was made of Estec SEC-3400S (Trade name). 13 denotes a heater and 12 denotes a temperature control device.

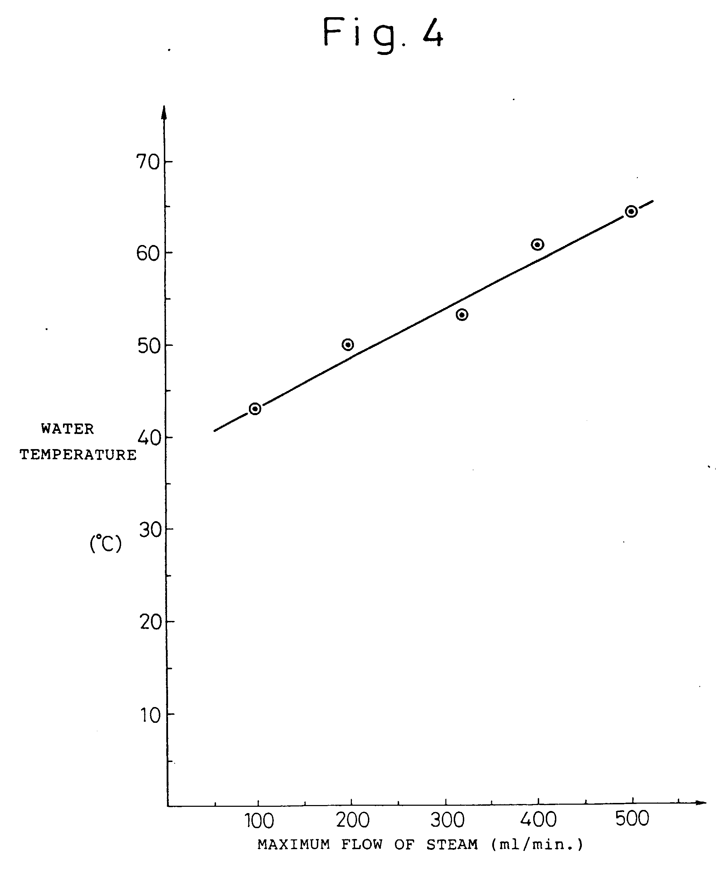

Fig. 4 shows the relationship between the maximum flow and water temperature. In this case, the mass-flow controller was full opened.

With the water temperature at 65 °C, the flow rate in the mass-flow controller was reduced by 50mℓ /min. When the flow rate was 300 mℓ /min., the mass-flow controller becomes blocked after 5 min. and the steam stops flowing.

If the water temperature was 50 °C , the mass-flow controller was blocked after 100 mℓ /min. Even if the mass-flow controller was changed to another one, substantially the same results are obtained.

The case that the embodiment of the steam supply system was applied to the ashing device will now be described.

The steam supply system shown in Fig. 3 was connected to the vacuum chamber of the ashing apparatus. After mixing the steam with the oxygen in the vacuum chamber, a microwave power of 2.45 GHz was charged on the vacuum chamber to generate plasma therein.

In this case, the water temperature was 60 °C, the flow of steam was 100 mℓ /min. and the flow of oxygen was 900 mℓ /min.

Flowing gas, turning on the plasma after 10 min. to start the ashing process. After 1 min., turning off the plasma and immediately the steam was changed to a bypass. The steam was introduced to the vacuum chamber after 1 min.

A steam supply test was carried out by repeating such series of operations under the conditions in a practical apparatus. It was found that, after about 20 sec. since the plasma was turned on three times, the color of plasma was changed from pink to blue and the steam stopped flowing. Thus, after removing foreign matters blocked in the mass-flow controller and reducing the water temperature to 50°C, the plasma processing was started again.

Next, the mass-flow controller was blocked fifteen times. The water temperature was then reduced to 48°C and the mass-flow controller was not blocked, but the plasma processing could be done for 50 times.

In the same manner, having conducted an experiment to determine the water temperature to give stable flow of the steam at 200 mℓ/min. and 300 mℓ/min, the results were 58 °C and 60 °C, respectively.

That is to say, it was found that, if the flow was less than a half of the maximum flow for respective water temperature. the mass-flow controller was blocked.

The above-mentioned embodiments are involved in the following advantages.
1) The inner surface of the pipe for supplying steam to the vacuum chamber is coated with tritetrafluoroethylene to easily prevent any contamination and keep the temperature.
2) There is a bypass which does not supply the steam via the vacuum chamber, but supply directly to the vacuum pump, when it is not necessary to supply the steam to the vacuum chamber.

Examples of the processing apparatus of this invention are as follows.
(1) A plasma processing apparatus in which a gas including at least steam is changed to plasma.
(2) A plasma downstream apparatus in which plasma and works are treated separately.
(3) A plasma downstream apparatus in which a gas including at least steam is introduced to the downstream of plasma.
(4) An ashing apparatus in which an ashing process is carried out on an organic substance in the above-mentioned plasma downstream apparatus.

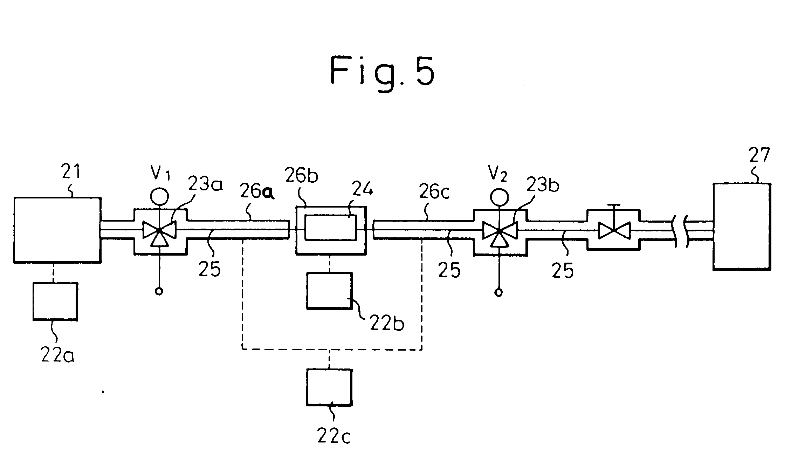

Fig. 5 is a view showing another embodiment of a steam supplying apparatus and a method for controlling the same. The illustrated steam supplying apparatus can be applied to a pressure reduction CVD or the like. In Fig. 5, reference numeral 21 denotes a closed water tank; 22a, 22b and 22c, temperature control means; 23a and 23b, valves; 24, mass-flow controller; 25, pipes; 26a, 26b and 26c, heaters; and 27, vacuum chamber.

As shown in Fig. 5, the steam supplying apparatus of this embodiment is one in which steam is supplied from the closed water tank 21 via the mass-flow controller 24 to the vacuum chamber 27. Particularly, the water tank 21 has the temperature control means 22a, the mass-flow controller 24 has the heater 26a and the temperature control means 22b, and the pipes 25, including the heater 26a and 26b and the temperature control means 22c, from the water tank 21 to the mass-flow controller 24 and from the mass-flow controller 24 to the vacuum chamber 27. The water tank 21, the mass-flow controller 24 and the pipes 25 are constructed so that their temperature can be controlled independently from each other.

A water supplying method according to the above-embodiment will now be described.

First, the flow rate from the water tank 21 is determined by the amount of steam, which is maintained by controlling the temperature of water tank 21 with a double-bath system by the temperature control means 22a. The water temperature in the pipes other than the water tank 21, i.e. the pipes 25 from the water tank 21 to the mass-flow controller 24 an from the mass-flow controller 24 to the vacuum chamber 27 are controlled by the heaters 26a and 26b enclosing these pipes and the temperature control means 22c. The temperature in the mass-flow controller 24 is controlled by the heater 26b enclosing the mass-flow controller 24 and the temperature control means 22b.

The water temperature in the water tank 21 necessary to supply the steam flow of 1100 cm³/min. to the vacuum chamber 27 is 60 °C. The temperature in the pipe 25 was 60 °C and that in the mass-flow controller 24 was 80 °C. Although in the prior art the steam was blocked in the mass-flow controller 24 in 5 min., in this embodiment, the pipe was not blocked, but the steam could be constantly supplied for over 1 hour at about 1000 cm³/min. In addition, since the temperature in the pipe 25 was 60 °C and that in the mass-flow controller 24 was 80 °C, it was not necessary to raise the temperature (60 °C) in the water tank 21 too much as compared with the prior art and, therefore, a fluorine resin, without metal, can be used as the material of the pipes.

As described above, steam can be supplied with easy control of the water temperature, less contamination and a stable flow. As a result a stable ashing rate can be obtained and, therefore, an accuracy can be improved in a wafer process. Particularly, the present invention can thus be effetively used in the manufacture of semiconductor devices or the like.

According to the second embodiment, it is not necessary to raise the temperature too much in the pipes other than the water tank, valves and the mass-flow controller and the steam in the mass-flow controller is not be blocked, so that it will be possible to stably supply the steam. Therefore, in the same manner, the present invention can thus be effectively used in the manufacture of semiconductor devices or the like.

## Claims

1. Steam supplying apparatus for supplying steam to a vacuum chamber (8, 27), characterised in that the apparatus comprises a closed chamber (2, 21) for containing water to be evaporated, the chamber (2, 21) having a ratio of maximum horizontal cross-sectional area (m) to minimum horizontal cross-sectional area (s) of less than 8:1, the inner surface coated with resin to minimise contamination of steam produced in the apparatus, a steam outlet (10, 25) and a means (13, 22a) for heating the closed chamber (2, 21).

2. A steam supplying apparatus according to claim 1, in which the means for heating the closed chamber (2) is a temperature controlled liquid bath.

3. A steam supplying apparatus according to claim 1 or 2, further comprising a mass-flow controller (11, 24) is provided between the closed chamber (2, 21) and the vacuum chamber (8, 27) adapted to control the flow rate of the steam to between 50 and 100% of the maximum flow rate determined by the vapour pressure of the system.

4. A steam supplying apparatus according to claim 3, adapted so that the water temperature in the closed chamber (2, 21) can be controlled so that the maximum flow rate is smaller than the maximum flow rate capacity of the mass-flow controller (11, 24).

5. A steam supplying apparatus according to claim 3 or 4, further comprising heaters (26a, 26c) for controlling the temperature (Tp) of pipes (25) connecting the closed chamber (2, 21) to the mass-flow controller (11, 24) and the mass-flow controller (11, 24) to vacuum chamber (8, 27).

6. A steam supplying apparatus according to claims 3 to 5, further comprising a heater (22b) for controlling temperature (Tm) of mass-flow controller (11, 24).

7. A steam supplying apparatus according to claims 3 to 6, comprising means to set the temperature (Tt) in the closed chamber 2, 21) to be not greater than the temperature (Tp) in the pipes (25) connecting the closed chamber (2, 21) to the mass-flow controller (11, 24) and the mass-flow controller (11, 24) to the vacuum chamber (8, 27), which is adapted to be set not greater than the temperature (Tm) in the mass-flow controller (11, 24).

8. A steam supplying apparatus according to any of the preceding claims in which the resin coating is tetrafluoroethylene.

## Patentansprüche

1. Dampfzuführungsgerät zum Zuführen von Dampf zu einer Vakuumkammer (8, 27), dadurch **gekennzeichnet,** daß das Gerät eine geschlossene Kammer (2, 21) zum Aufnehmen von zu verdampfendem Wasser umfaßt, wobei die Kammer (2, 21) ein Verhältnis der maximalen horizontalen Querschnittsfläche (m) zur minimalen horizontalen Querschnittsfläche (s) von weniger als 8:1 hat, wobei die innere Oberfläche mit Harz beschichtet ist, um eine Verschmutzung des in dem Gerät produzierten Dampfes zu minimieren, einen Dampfauslaß (10, 25) und ein Mittel (13, 22a) zum Heizen der geschlossenen Kammer (2, 21).

2. Daampfzuführungsgerät nach Anspruch 1, bei welchem das Mittel zum Heizen der geschlossenen Kammer (2) ein temperaturgesteuertes Flüssigkeitsbad ist.

3. Dampfzuführungsgerät nach Anspruch 1 oder 2, ferner umfassend, daß eine Mengenstromsteuerung (11, 24) zwischen der geschlossenen Kammer (2, 21) und der Vakuumkammer (8, 27) vorgesehen ist, die dazu ausgelegt ist, die Stromrate des Dampfes auf zwischen 50 und 100 % der maximalen Stromrate zu regeln, die durch den Dampfdruck des Systems bestimmt ist.

4. Dampfzuführungsgerät nach Anspruch 3, welches so ausgelegt ist, daß die Wassertemperatur in der geschlossenen Kammer (2, 21) so gesteuert werden kann, daß die maximale Stromrate kleiner als die maximale Stromratenkapazität der Mengenstromsteuerung (11, 24) ist.

5. Dampfzuführungsgerät nach Anspruch 3 oder 4, ferner umfassend Heizgeräte (26a, 26c) zum Steuern der Temperatur (Tp) der Leitungen (25), welche die geschlossene Kammer (2, 21) mit der Mengenstromsteuerung (11, 24) und die ms (11, 24) und die Mengenstromsteuerung (11, 24) mit der Vakuumkammer (8, 27) verbinden.

6. Dampfzuführungsgerät nach den Ansprüchen 3 bis 5, ferner umfassend ein Heizgerät (22b) zum Steuern der Temperatur (Tm) der Mengenstromsteuerung (11, 24).

7. Dampfzuführungsgerät nach den Ansprüchen 3 bis 6, umfassend Mittel, um die Temperatur (Tt) in der geschlossenen Kammer (2, 21) nicht höher als die Temperatur (Tp) in den die geschlossene Kammer (2, 21) mit der Mengenstromsteuerung (11, 24) und die Mengenstromsteuerung (11, 24) mit der Vakuumkammer (8, 27) verbindenden Leitungen (25) einzustellen, die ihrerseits so eingestellt werden kann, daß sie nicht größer als die Temperatur (Tm) in der Mengenstromsteuerung (11, 24) ist.

8. Dampfzuführungsgerät nach einem der vorangehenden Ansprüche, bei welchem die Harzbeschichtung aus Tetrafluorethylen besteht.

## Revendications

1. Appareil de transmission de vapeur d'eau destiné à transmettre de la vapeur d'eau à une chambre sous vide (8, 27), caractérisé en ce que l'appareil comprend une chambre fermée (2, 21) destinée à contenir de l'eau à évaporer, la chambre (2, 21) ayant un rapport de sa section horizontale maximale (m) à sa section horizontale minimale (s) inférieur à 8/1, la surface interne étant revêtue d'une résine destinée à réduire au minimum la contamination de la vapeur d'eau produite dans l'appareil, une sortie (10, 25) de vapeur d'eau, et un dispositif (13, 22a) de chauffage de la chambre fermée (2, 21).

2. Appareil de transmission de vapeur d'eau selon la revendication 1, dans lequel le dispositif de chauffage de la chambre fermée (2) est un bain de liquide à température réglée.

3. Appareil de transmission de vapeur d'eau selon la revendication 1 ou 2, comprenant en outre un organe (11, 24) de réglage de débit massique placé entre la chambre fermée (2, 21) et la chambre sous vide (8, 27) et destiné à régler le débit massique de la vapeur d'eau entre 50 et 100 % du débit maximal déterminé par la pression de vapeur du système.

4. Appareil de transmission de vapeur d'eau selon la revendication 3, réalisé de manière que la température de l'eau dans la chambre fermée (2, 21) puisse être réglée à une valeur telle que le débit maximal est inférieur au débit maximal possible dans l'organe (11, 24) de réglage de débit massique.

5. Appareil de transmission de vapeur d'eau selon la revendication 3 ou 4, comprenant en outre des organes de chauffage (26a, 26c) destinés à récler la température (Tp) des tubes (25) qui relient la chambre fermée (2, 21) à l'organe de réglage de débit massique (11, 24) et l'organe de réglage de débit massique (11, 24) à la chambre sous vide (8, 27).

6. Appareil de transmission de vapeur d'eau selon les revendications 3 à 5, comprenant en outre un organe de chauffage (22b) destiné à régler la température (Tm) de l'organe de réglage de débit massique (11, 24).

7. Appareil de transmission de vapeur d'eau selon les revendications 3 à 6, comprenant un dispositif destiné à régler la température (Tt) dans la chambre fermée (2, 21), afin qu'elle ne dépasse pas la température (Tp) dans les tubes (25) qui raccordent la chambre fermée (2, 21) à l'organe de réglage de débit massique (11, 24) et l'organe de réglage de débit massique (11, 24) à la chambre sous vide (8, 27), et qui est destiné à être réglé à une température qui ne dépasse pas la température (Tm) dans l'organe de réglage de débit massique (11, 24).

8. Appareil de transmission de vapeur d'eau selon l'une quelconque des revendications précédentes, dans lequel le revêtement de résine est formé de tétrafluoréthylène.
